# EUROPÄISCHE PATENTSCHRIFT

(11) **EP 0 944 746 B1**
(45) Veröffentlichungstag und Bekanntmachung des Hinweises auf die Patenterteilung: **04.07.2001**
(21) Anmeldenummer: 97951813.1
(22) Anmeldetag: 26.11.1997
(51) Int. Cl.: C23C 30/00, C23C 4/10, C23C 14/08

(54) **ERZEUGNIS, WELCHES EINEM HEISSEN GAS AUSSETZBAR IST, MIT EINER WÄRMEDÄMMSCHICHT SOWIE VERFAHREN ZUR HERSTELLUNG**
HOT-GAS EXPOSABLE PRODUCT FITTED WITH A HEAT-INSULATING LAYER AND A METHOD FOR THE PRODUCTION THEREOF
PRODUIT POUVANT ETRE EXPOSE A UN GAZ CHAUD, POURVU D'UNE COUCHE CALORIFUGE, ET SON PROCEDE DE PRODUCTION

(30) Priorität: 10.12.1996 DE 19651273
(43) Veröffentlichungstag der Anmeldung: 29.09.1999
(73) Patentinhaber: SIEMENS AKTIENGESELLSCHAFT, 80333 München (DE)
(72) Erfinder: BEELE, Wolfram, D-40883 Ratingen (DE)
(86) Internationale Anmeldenummer: DE9702769
(87) Internationale Veröffentlichungsnummer: WO9826110

(56) Entgegenhaltungen:
- EP-A- 0 684 322
- WO-A-96/31293
- WO-A-96/34128
- WO-A-97/01436
- US-A- 4 880 614
- US-A- 4 971 839
- US-A- 5 223 045
- SIVAKUMAR, R. ET AL: "On the development of plasma-sprayed thermal barrier coatings" OXID. MET. (1983), 20(3-4), 67-73 CODEN: OXMEAF;ISSN: 0030-770X, XP002060780

## Beschreibung

Gegenstand der Erfindung ist ein keramikbeschichtetes Erzeugnis, insbesondere ein Bauteil, für die Verwendung in einem Heißgaskanal, insbesondere in Industriegasturbinen. Die Erfindung betrifft weiterhin ein Verfahren zur Herstellung eines Erzeugnisses mit einer Wärmedämmschicht.

Solch ein Erzeugnis weist einen Grundkörper mit einer Metallegierung auf der Basis von Nickel, Kobalt oder Eisen auf. Derartige Erzeugnisse dienen vor allem als Bauteil einer Gasturbine, insbesondere als Gasturbinenschaufeln oder Hitzeschilde. Die Bauteile sind einem Heißgasstrom von aggressiven Verbrennungsgasen ausgesetzt. Daher müssen sie hohen thermischen Belastungen Stand halten können. Des weiteren ist es erforderlich, daß diese Bauteile oxidations- und korrosionsbeständig sind. Vor allem an bewegliche Bauteile, z.B. Gasturbinenschaufeln, aber auch an statische Bauteile sind fernerhin mechanische Anforderungen zu stellen. Die Leistung und der Wirkungsgrad einer Gasturbine, in der heißgasbelastbare Bauteile Verwendung finden, steigen mit zunehmender Betriebstemperatur. Um einen hohen Wirkungsgrad und eine hohe Leistung zu erzielen, werden durch die hohen Temperaturen besonders belastete Komponenten der Gasturbinen mit einem keramischen Werkstoff beschichtet. Dieser wirkt als Wärmedämmschicht zwischen dem Heißgasstrom und dem metallischen Substrat.

Vor dem aggressiven Heißgasstrom wird der metallische Grundkörper durch Beschichtungen geschützt. Dabei weisen moderne Bauteile zumeist mehrere Beschichtungen auf, die jeweils spezifische Aufgaben erfüllen. Es liegt somit ein Mehrschichtsystem vor.

Da Leistung und Wirkungsgrad von Gasturbinen mit zunehmender Betriebstemperatur steigen, wurde immer wieder versucht, durch Verbesserung des Beschichtungssystemes eine höhere Leistungsfähigkeit von Gasturbinen zu erzielen.

Ein erster Verbesserungsansatz besteht in der Optimierung der Haftschicht. In der US-PS 4,321,310 ist angegeben, eine MCrAlY-Haftschicht so aufzubringen, daß sie eine geringe Oberflächenrauhigkeit aufweist. Darauf bildet sich sodann eine Schicht aus Aluminiumoxid. Dadurch soll eine wesentliche Verbesserung der Haftung der Wärmedämmschicht erreicht werden.

Die US-PS 4,880,614 gibt an, zwischen die Haftschicht aus MCrAlY und den metallischen Grundkörper eine hochreine Aluminiumschicht einzubringen. Dieses Aluminium dient zur Bildung einer dichten Al₂O₃-Schicht auf der Haftschicht. Durch diese Maßnahme soll die Lebensdauer der beschichteten Bauteile erhöht werden.

In der US-PS 5,238,752 wird eine Haftschicht aus Nickelaluminiden oder Platinaluminiden angegeben. Auf dieser Haftschicht entsteht eine Schicht aus Aluminiumoxid. Hierauf wird die Wärmedämmschicht aufgebracht.

In der US-PS 5,262,245 ist beschrieben, daß sich die Aluminiumoxidschicht als Oxidationsschicht aus dem Werkstoff des Grundkörpers bildet. Der Grundkörper weist dazu eine Nickelbasis-Legierung auf, die stark oxidbildende Legierungsbestandteile aufweist.

In der US-PS 4,676,994 ist angegeben, auf einen Grundkörper eine Aluminiumoxid bildende Schicht aufzutragen. An der Oberfläche dieser Schicht bildet sich Aluminiumoxid. Hierauf wird eine dichte keramische Schicht aufgedampft. Diese keramische Schicht besteht aus einem dichten unterstöchiometrischen keramischen Material. Sie kann ein Oxid, Nitrid, Carbid, Borid, Silizid oder ein anderes refraktärkeramisches Material sein. Auf diese keramische Schicht wird eine Wärmedämmschicht aufgebracht.

Der ganz überwiegende Teil der obigen US-Patentschriften gibt an, daß die Wärmedämmschicht eine kolumnare Mikrostruktur aufweist. Dabei stehen die Kristallitsäulen der kolumnaren Mikrostruktur senkrecht zur Oberfläche des Grundkörpers. Als keramischer Werkstoff wird stabilisiertes Zirkonoxid angegeben. Als Stabilisator kommen in Betracht Kalziumoxid, Magnesiumoxid, Ceroxid und bevorzugt Yttriumoxid. Der Stabilisator ist erforderlich, um eine Phasenumwandlung von der kubischen in die tetragonale und schließlich monokline Kristallstruktur zu verhindern. Stabilisiert wird im wesentlichen die tetragonale Phase zu etwa 90 %.

In der US-PS 4,321,311 sind voluminöse Fehlstellen in der Wärmedämmschicht vorgesehen, um Spannungen abzubauen, die in der Wärmedämmschicht bei Temperaturänderungen dadurch entstehen, daß Grundkörper und Wärmedämmschicht unterschiedliche thermische Ausdehnungskoeffizienten aufweisen. Die Wärmedämmschicht weist einen kolumnaren Aufbau auf, wobei zwischen den einzelnen Säulen der Beschichtung aus Yttriumoxid stabilisiertem Zirkoniumoxid Lücken bestehen sollen.

Einen anderen Vorschlag zur Lösung des Spannungsproblemes bei Temperaturwechsel ist in der US-PS 5,236,787 angegeben. Hierin wird zwischen dem Grundkörper und der Wärmedämmschicht eine Zwischenschicht eingebracht, die aus einer Metall-Keramik-Mischung besteht. Dabei soll der metallische Anteil dieser Zwischenschicht zum Grundkörper hin zunehmen und zur Wärmedämmschicht abnehmen. Umgekehrt soll der keramische Anteil in Nähe des Grundkörpers niedrig, in Nähe der Wärmedämmschicht hoch sein. Als Wärmedämmschicht wird ein Yttriumoxid stabilisiertes Zirkonoxid mit Anteilen von Ceroxid vorgeschlagen. Die Wärmedämmschichten werden durch Plasmaspritzen oder PVD-Prozesse auf den Grundkörper abgeschieden. Der Anteil des Yttriumoxid-Stabilisators beträgt 8 bis 20 Gew.-%.

In der US-PS 4,764,341 ist das Anbinden einer dünnen Metallschicht auf einer Keramik beschrieben. Für die Metallschicht werden Nickel, Kobalt, Kupfer, sowie Legierungen dieser Metalle verwendet. Zur Anbindung der Metallschicht an das keramische Substrat wird auf das keramische Substrat ein Zwischenoxid wie Aluminiumoxid, Chromoxid, Titanoxid oder Zirkonoxid, aufgebracht, welches bei einer hinreichend hohen Temperatur durch Oxidation ein ternäres Oxid unter Einbeziehung eines Elementes der metallischen Beschichtung bildet.

Aufgabe der Erfindung ist es, ein Erzeugnis mit einer Wärmedämmschicht anzugeben, das einem heißen Gas aussetzbar ist. Eine weitere Aufgabe besteht darin, ein Verfahren zur Herstellung eines Erzeugnisses mit einer Wärmedämmschicht anzugeben.

Die Erfindung geht von der Erkenntnis aus, daß bisherige Wärmedämmschicht-Werkstoffe vorwiegend pseudobinäre Keramiken aufweisen. Darunter sind solche Keramikwerkstoff zu verstehen, deren allgemeine Strukturformel mit AB₂ oder A₂B₃ angegeben werden kann. Am vorteilhaftesten erwies sich hierbei ein Werkstoff auf Zirkonoxid-Basis. Jedoch zeigt Zirkonoxid bereits ab 900 °C Alterungserscheinungen. Diese werden dadurch hervorgerufen, daß die Zirkonoxidwärmedämmschicht sintert. Hierdurch werden in zunehmendem Maße die Poren und voluminösen Fehlstellen in der Wärmedämmschicht abgebaut. Die infolge der unterschiedlichen thermischen Ausdehnungskoeffizienten von Wärmedämmschicht-Werkstoff und Grundkörper-Werkstoff hervorgerufenen Spannungen können somit zunehmend schlechter abgebaut werden. Verstärkt wird dieser Sintervorgang durch Werkstoffverunreinigungen. Eine weitere Verstärkung erfährt er durch Wechselwirkung der Wärmedämmschicht mit Heißgasbestandteilen, mit Grundkörperwerkstoffen und dem Haftschichtwerkstoff. Vor allem das als Stabilisator eingesetzte Yttriumoxid fördert die Alterung. Da eine lange Betriebsdauer von Gasturbinen im Vollastbetrieb von z.B. 10.000 Stunden wünschenswert ist, ist die zulässige Oberflächentemperatur von Bauteilen mit Zirkonoxidwärmedämmschichten auf 1250 °C beschränkt. Durch diese maximal zulässige Oberflächentemperatur werden Leistung und Wirkungsgrad von Gasturbinen festgelegt und begrenzt.

Erfindungsgemäß weist das Erzeugnis eine Wärmedämmschicht mit einer Keramik mit einem ternären oder pseudo-ternären Oxid auf, dadurch gekennzeichnet, daβ das Oxid eine Pyrochlor-Struktur der Strukturformel A₂B₂O₇ aufweist oder eine Perowskit-Kristallstruktur der Strukturformel ABO₃ aufweist, wobei entweder A für Ytterbium oder A für Kalzium und B für Hafnium steht. Der Werkstoff der Wärmedämmschicht weist bevorzugt von Raumtemperatur bis zur Schmelztemperatur keine Phasenumwandlung auf. Die Zugabe eines Stabilisators ist dann nicht erforderlich. Die Schmelztemperatur hängt von der jeweiligen chemischen Verbindung ab. Sie beträgt vorzugsweise über 2150 °C liegen.

Vorzugsweise ist zwischen dem Grundkörper und der Wärmedämmschicht eine Anbindungsschicht mit einem Anbindungsoxid angeordnet. Diese Schicht kann beispielsweise durch Aufbringen eines Oxides erzeugt werden. Bevorzugt bildet sich allerdings die Anbindungsschicht durch Oxidation einer Haftvermittlerschicht, welche Haftvermittlerschicht zwischen der Wärmedämmschicht und dem Grundkörper angeordnet ist. Die Oxidation der Haftvermittlerschicht kann bereits vor Aufbringen der Wärmedämmschicht oder aber auch während eines Einsatzes des Erzeugnisses in einer Sauerstoff enthaltenden Atmosphäre erfolgen. Die Haftvermittlerschicht weist hierbei bevorzugt ein ein Oxid bildendes metallisches Element auf. Es ist ebenfalls möglich, daß die Anbindungsschicht unmittelbar durch eine Oxidation der Legierung des metallischen Grundkörpers gebildet wird. Hierzu weist die Legierung des Grundkörpers ein entsprechendes metallisches Element auf. Das Anbindungsoxid ist vorzugsweise Chromoxid und/oder Aluminiumoxid.

Das Erzeugnis ist vorzugsweise ein Bauteil einer thermischen Maschine, wie beispielsweise eine Gasturbinenschaufel, eine Hitzeschildkomponente einer Brennkammer einer Gasturbine oder ein Bauteil eines Verbrennungsmotors. Die Bauteile der Gasturbine, z.B. Turbinenschaufeln oder Hitzeschilde, weisen dabei bevorzugt einen Grundkörper auf, der aus einer Superlegierung auf Nickel-, Chrom- oder Eisenbasis besteht. Auf diesem Grundkörper befindet sich insbesondere eine MCrAlY-Haftvermittlerschicht. Sie dient auch als Oxidationsschutzschicht, da an Luft oder praktisch jeder anderen sauerstoffhaltigen Umgebung (spätestens also beim Einsatz'des Bauteils) ein Teil des Aluminiums und/oder Chroms in Oxid überführt wird. Auf dieser Haftvermittlerschicht befindet sich die Wärmedämmschicht. Sie besteht aus einem ternären oder pseudoternären Oxid. Dieses weist vorzugsweise eine Pyrochlor- oder Perowskit-Struktur auf. Unter einem ternären Oxid wird dabei eine Substanz verstanden, die aus Atomen von drei verschiedenen chemischen Elementen besteht. Unter einem pseudoternären Oxid wird eine Substanz verstanden, die an sich Atome von mehr als drei verschiedenen chemischen Elementen aufweist, diese Atome aber nur zu drei unterschiedlichen Elementgruppen gehören, wobei die Atome der einzelnen Elemente in jeweils einer der drei unterschiedlichen Elementgruppen in kristallographischer Hinsicht gleichwirkend sind.

Diese keramischen Substanzen zeigen eine für Wärmedämmschichten zu fordernde niedrige Wärmeleitfähigkeit. Die Wärmeleitfähigkeit ist insbesondere bei höheren Temperaturen mit der von Zirkonoxid vergleichbar. Des weiteren haben die keramischen Substanzen der Wärmedämmschicht einen thermischen Ausdehnungskoeffizienten, der mit dem thermischen Ausdehnungskoeffizienten des Grundkörperwerkstoffs kompatibel ist. Der Wärmeausdehnungskoeffizient liegt bei ca. 9*10⁻⁶ /K. Die ternäre Oxide aufweisenden keramischen Substanzen der Wärmedämmschicht sind vorzugsweise zwischen Raumtemperatur und Schmelztemperatur phasenstabil. Damit erübrigt sich ein Stabilisator, der die Alterungseigenschaft fördert. Des weiteren ist gewährleistet, daß sie vermittels der Haftvermittlungsschicht aus MCrAlY stabil auf dem Grundkörper haften. Weiterhin ist hervorzuheben, daß die Abdampfraten der keramischen Substanzen der Wärmedämmschicht sehr gering sind. Größenordnungsmäßig beträgt z.B. die Abdampfrate von Lanthanhafnat 0,4 *µ*m pro 1000 Stunden bei 1600 °C.

Erfindungsgemäß wird die auf ein Verfahren zur Aufbringung von Wärmedämmschichten gerichtete Aufgabe gelöst, indem die Beschichtung mit einem ternären Oxid, das eine Pyrochlor- kristallstruktur der Strukturformel A₂B₂O₇ aufweist, durch atmosphärisches Plasmaspritzen oder ein PVD-Verfahren, z.B. ein EB-PVD (Electron Beam Physical Vapor Deposition)-Verfahren, erfolgt. Bei beiden Verfahren läßt sich mit geeigneter Wahl der Verfahrensparameter eine Schicht mit gewünschter Porosität erzeugen. Es kann auch eine kolumnare Mikrostruktur erzeugt werden. Es ist dabei nicht notwendig erforderlich, daß das zur Beschichtung dienende Ausgangsmaterial bereits von gleicher chemischer und kristallographischer Beschaffenheit ist, wie das Material der fertigen Beschichtung. Vor allem bei Lanthanhafnat ist es möglich, für das Ausgangsmaterial des Beschichtungsverfahrens eine Pulvermischung einzusetzen, die aus zwei binären Oxiden besteht. Das Massenverhältnis der beiden Pulver entspricht dabei der stöchiometrischen Zusammensetzung der alsdann durch das Beschichtungsverfahren gebildeten Wärmedämmschicht auf dem Bauteil. Beispielsweise kann man eine Wärmedämmschicht aus Lanthanhafnat dadurch erzeugen, daß in einem EB-PVD-Prozeß als Ausgangsmaterial eine Mischung von Hafniumoxid und Lanthanoxid eingesetzt wird. Hierbei beträgt dann das molare Verhältnis von Hafniumoxid zu Lanthanoxid 1,29.

Nachfolgend werden keramische Substanzen mit einem ternären oder pseudoternären Oxid gemäß Anspruch 1 und/oder 5 für die Wärmedämmschicht, anhand eines Ausführungsbeispiels näher beschrieben. Es zeigen:
- FIG 1: eine Draufsicht auf eine Ebene der Pyrochlor-Struktur;
- FIG 2: einen Ausschnitt aus der Elementarzelle einer Pyrochlor-Struktur;
- FIG 3: eine Einheitszelle der Perowskit-Struktur;
- FIG 4: eine Einheitszelle der Perowskit-Struktur, wobei diese gegenüber der aus Fig. 1 um 1/2, 1/2, 1/2 verschoben ist;
- FIG 5: einen Querschnitt durch einen Ausschnitt einer Turbinenschaufel.

Bei einer Wärmedämmschicht aus einer keramischen Substanz eines ternären Oxids mit Pyrochlorstruktur weist die Kristallstruktur 88 Atome pro Elementarzelle auf. Die allgemeine chemische Strukturformel solcher ternärer Oxide lautet A₂B₂O₇. Dabei handelt es sich bei "A" und "B" um Metallionen. "O" steht für Sauerstoff.

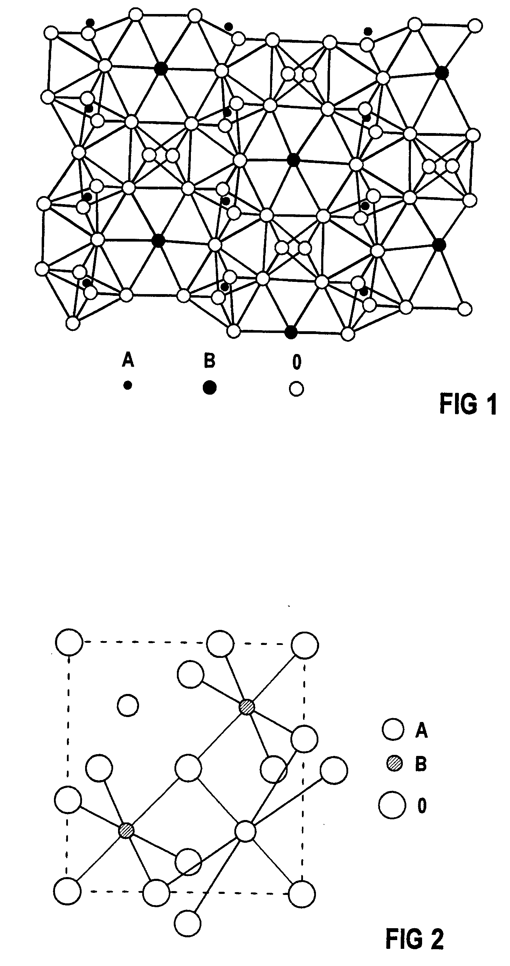

Die Pyrochlor-Struktur wird nachfolgend beschrieben (Figur 1). Die relativ kleineren B-Kationen koordinieren sich mit Sauerstoffatomen in Form eines Oktaeders. Diese Oktaeder bilden ein dreidimensionales Netzwerk, bei dem die benachbarten Oktaeder sich jeweils ein Sauerstoffatom teilen. Die relativ größeren A-Kationen befinden sich dabei in einem hexagonalen Ring, der von den Sauerstoffatomen der Koordinierungsoktaeder der B-Kationen gebildet wird. Senkrecht zur Ringfläche befinden sich über und unter dem jeweiligen A-Kation ein Sauerstoffatom. Seine Bindungslänge ist dabei etwas kürzer als die Bindungslänge zu den Sauerstoffatomen des Rings. Somit koordiniert sich ein A-Kation mit Sauerstoff in Form einer hexagonalen Bi-Pyramide. Eine andere Beschreibung der Pyrochlor-Struktur (Figur 2) gibt an, daß die Struktur zusammengesetzt ist aus zwei Typen von Koordinationspolyedern der Kationen. Dabei koordinieren das relativ kleinere B-Kation sechs äquidistante Sauerstoffatome in Form von trigonalen Antiperismen.

Das größere A-Kation wird durch sechs äquidistante Sauerstoffatome koordiniert und zwei weitere Sauerstoffatome mit etwas kürzerer Bindungslänge. Diese acht Sauerstoffatome bilden einen verdrehten Kubus um das A-Kation.

Schwierigkeiten, die Struktur zu beschreiben, treten insbesondere deshalb auf, weil bei verschiedenen Bindungslängen zwischen den Kationen und Sauerstoffatomen - je nachdem welche chemischen Elemente konkret für die A- und B-Kationen vorliegen - die Koordinationspolyeder verzerrt werden. Es erscheint daher so, daß pulverdiffraktometrische Messungen keine sicheren Schlüsse auf die gegenseitige Koordination der verschiedenen Atome zulassen. Insoweit ist es erforderlich und zur Kennzeichnung der Pyrochlorstruktur hinreichend, diese über die 2θ-Werte aus der pulverdifraktometrischen Messung zu charakterisieren. In der folgenden Tabelle sind die 2 θ-Werte der für Pyrochlor charakteristischen Intensitäten und die zugehörigen hkl-Werte aufgeführt.

| | |
|---|---|
| **2θ** | **hkl** |
| 29.2 | 111 |
| 33.2 | 200 |
| 47.8 | 220 |
| 56.7 | 311 |
| 59.4 | 222 |
| 69.8 | 400 |
| 77.2 | 331 |
| 79.6 | 420 |
| 89.0 | 511/311 |

Aufgrund von Verunreinigungen des Untersuchungspulvers kann es zu geringfügigen Abweichungen von den 2θ-Werten im Bereich der ersten Dezimalstelle kommen. Bei der pulverdiffraktometrischen Messung können auch systematische Fehler auftreten. Diese können sich grundsätzlich in zwei Arten auf die gemessenen 2θ-Werte auswirken: Zum einen können sich die gemessenen 2θ-Werte insgesamt zu größeren oder zu kleineren 2θ-Werten hin verschieben. Hierbei bleibt jedoch der Abstand zwischen zwei benachbarten 2θ-Werten gleich. Zum anderen kann es vorkommen, daß die Intensitäten insgesamt gestreckt oder gestaucht auf der 2θ-Skala erscheinen. Dann ist aber das Verhältnis der Abstände benachbarter 2θ-Werte bei der gemessenen Probe gleich dem Verhältnis der entsprechenden Abstände benachbarter 2θ-Werte der angegebenen Tabelle.

Die A- und B-Kationen in der allgemeinen chemischen Strukturformel stehen vorzugsweise für Selten-Erd-Metalle und Aluminium (allgemein: A³⁺ -Kationen) und Hafnium, Zirkon und Ce (allgemein: B⁴⁺ -Kationen).

Für eine Wärmedämmschicht mit einem ternären Oxid, insbesondere mit Pyrochlorstruktur, sind folgende Substanzen vorzugsweise geeignet: Lanthanhafnat (La₂Hf₂O₇), Lanthanzirkonat (La₂Zr₂O₇), Aluminiumhafnat (Al₂Hf₂O₇), Cerhafnat (Ce₂Hf₂O₇), Cerzirkonat (Ce₂Zr₂O₇), Aluminiumcerat (Al₂Ce₂O₇) und Lanthancerat (La₂Ce₂O₇) - Innerhalb der geeigneten Beschichtungswerkstoffe mit Pyrochlorstruktur sind auch pseudoternäre Oxide enthalten. Diese können beispielsweise die Strukturformel-La2(HfZr)O₇ oder (CeLa)Hf₂O₇ aufweisen. Des weiteren kommen Verbindungen mit nicht ganzzahligen Indizes in Betracht, z.B. La₂ (Hf_{1,5}Zr_{0,5})O₇. Es ist auch möglich, daß sowohl die A-Ionen als auch die B-Ionen gleichzeitig mehrere Elemente aufweisen.

Diese Verbindungen zeichnen sich dadurch aus, daß sie gegenüber den sie konstituierenden Elementen einen Löslichkeitsbereich von mehreren Mol-% aufzeigen. Dadurch wird die Bildung von Ausscheidungen bei dicht über- oder unterstöchiometrischer Zusammensetzung vermieden. Sie zeichnen sich des weiteren dadurch aus, daß sie über einen weiteren Temperaturbereich phasenstabil sind. Dies bedeutet, daß die Pyrochlor-struktur im für den Betrieb von Heißgaskanälen relevanten Temperaturbereich erhalten bleibt. So ändern La₂Hf₂O₂ und La₂Zr₂O₇ ihre Kristallstruktur erst oberhalb 1500 °C. Damit erübrigt sich auch eine Beifügung von Stabilisator. Infolgedessen scheidet eine die Werkstoffalterung verstärkende Wirkung des Stabilisators aus. Die zulässige Betriebstemperatur kann folglich auf höhere Werte angehoben werden.

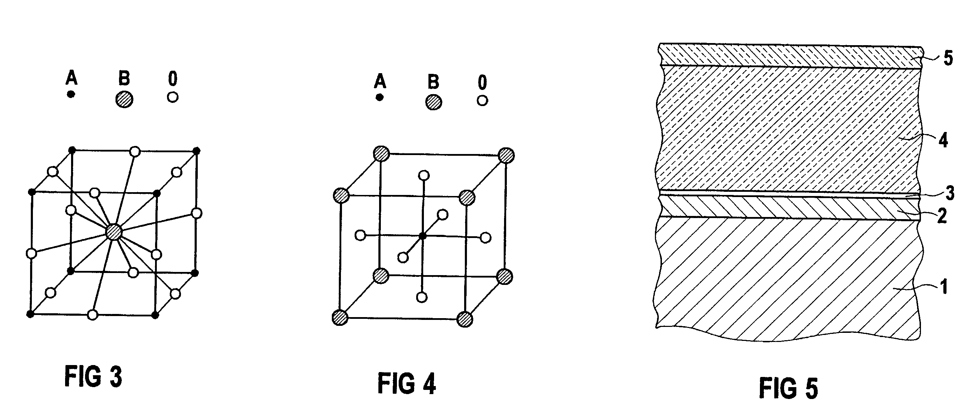

Die Beschichtungswerkstoffe mit Perowskitstruktur haben die allgemeine chemische Strukturformel ABO₃. Verbindungen mit Perowskitstruktur unterscheiden sich von solchen mit Ilmenitstruktur, welche auch die allgemeine chemische Formel ABO₃ aufweisen, dadurch, daß die A-Ionen gegenüber den B-Ionen relativ kleiner sind. Die Perowskitstruktur ist kristallographisch hinreichend zuverlässig beschrieben. Sie ist wesentlich kleiner als die Pyrochlorstruktur. Die Perowskitstruktur weist vier Atome in der Elementarzelle auf. In Figur 3 ist eine Elementarzelle der Perowskitstruktur wiedergegeben. Figur 4 zeigt eine Elementarzelle der Perowskitstruktur, die gegenüber der Elementarzelle in Figur 3 um 1/2, 1/2, 1/2 verschoben ist. Die kleineren A-Kationen sind als Vollkreise, die größeren B-Kationen als schraffierte Kreise und die Sauerstoffanionen als Hohlkreise dargestellt. Wie aus Figur 3 und 4 zu erkennen ist, handelt es sich bei Perowskit um eine kubische Struktur. Darin besetzen die größeren B-Ionen die Ecken des Elementarwürfels, die kleineren A-Ionen sein Zentrum und die O-Ionen seine Flächenmitten (Figur 4). Die Struktur läßt sich auch so beschreiben, daß die größeren B-Ionen und die O-Ionen zusammen eine kubisch dichteste Kugelpackung bilden, in der 1/4 der oktaedrischen Lücken mit A-Ionen besetzt ist. Die B-Ionen werden von jeweils 12 O-Ionen in Form eines Kubo-Oktaeders koordiniert, den O-Ionen sind jeweils vier B-Ionen und zwei A-Ionen benachbart.

Als Material für Wärmedämmschichten werden bevorzugt die folgenden Verbindungen verwendet: Ytterbiumzirkonat (YbZrO₃), Ytterbiumhafnat (YbHfO₃), Calziumzirkonat (CaZrO₃) und Calziumhafnat (CaHfO₃). Besonders bevorzugt werden hierbei Ytterbiumzirkonat und Ytterbiumhafnat.

Auch bei Wärmedämmschichtwerkstoffen mit Perowskitstruktur ist es nicht erforderlich, daß alle Kationen der A- oder B-Gruppe dem gleichen Element angehören. So sind auch hier Verbindungen eines pseudoternären Oxides beispielsweise mit der Strukturformel Yb(Zr_{0,5}Hf_{0,5})O₃, etc. möglich.

Wie die Beschichtungswerkstoffe mit Pyrochlorstruktur zeigen auch die Werkstoffe mit Perowskitstruktur von Raumtemperatur bis zu hohen Temperaturwerten, wenn nicht bis zur Schmelztemperatur keine Phasenumwandlung. Aus diesem Grunde sind sie ähnlich vorteilhaft wie Beschichtungswerkstoffe mit Pyrochlorstruktur.

In Figur 5 ist ein Ausschnitt aus einer nicht näher dargestellten Gasturbinenschaufel oder einem Hitzeschildelement einer Brennkammer einer Gasturbine dargestellt. Auf einen Grundkörper 1, der aus einer Superlegierung, insbesondere auf Nickel-, Kobalt- oder Eisenbasis, besteht, ist eine Haftvermittlungsschicht 2 aufgebracht. Die Haftvermittlungsschicht 2 besteht aus einer Metall-Chrom-Aluminium-Yttrium-(MCrAlY)-Legierung. Die Haftvermittlungsschicht 2 dient dazu, die Haftung zwischen einer Wärmedämmschicht 4 und dem Grundkörper 1 zu gewährleisten. Das in der Haftvermittlungsschicht enthaltene Aluminium und/oder Chrom dient als Aluminiumoxid-/Chromoxidbildner. Es bildet eine Anbindungsschicht 3, insbesondere eine dichte Passivschicht, aus Aluminiumoxid bzw. Chromoxid, die als Sauerstoffbarriere den Grundkörper 1 vor Oxidation schützt. Die Wärmedämmschicht 4 wird auf den Grundkörper 1 bevorzugt durch atmosphärisches Plasmaspritzen oder durch ein PVD-Verfahren, z.B. EB-PVO-Verfahren, aufgebracht. Soweit atmosphärisches Plasmaspritzen als Auftragsverfahren eingesetzt wird, können die Verfahrensparameter so gewählt werden, daß sich in der Wärmedämmschicht 4 eine gewünschte Porosität einstellt. Mit einem EB-PVD-Verfahren läßt sich eine kolumnare Struktur der Wärmedämmschicht 4 erzeugen. Dabei stehen die Kristallitsäulen senkrecht zur Oberfläche des Grundkörpers 1. Die Wärmedämmschicht 4 besteht z.B. aus Lanthanhafnat. Die Wärmedämmschicht 4 weist eine relativ lockere Mikrostruktur auf. Sie enthält Poren oder andere voluminöse Fehlstellen. Auch als kolumnare Mikrostruktur ist sie durch ein relativ lockeres Gefüge gekennzeichnet. Dieses lockere Gefüge weist eine gewisse Erosionsanfälligkeit im Heißgasstrom auf. Als Schutz vor solchen Erosionserscheinungen kann die Oberfläche der Wärmedämmschicht 4 zu einer dichten und kompakten Schutzschicht 5 umgeschmolzen werden, wie hier dargestellt. Die Schutzschicht 5 kann beispielsweise durch Laserumschmelzen erzeugt werden.

Es ist ebenfalls möglich, daß die Wärmedämmschicht 4 unmittelbar auf den Grundkörper 1 aufgebracht wird. In diesem Fall ist bereits die Legierung des Grundkörpers 1 so ausgebildet, daß sie geeignet ist, ein Anbindungsoxid, z.B. Chromoxid und/oder Aluminiumoxid, zu bilden. Dieses Anbindungsoxid bildet dann die Anbindungsschicht 3.

## Patentansprüche

1. Erzeugnis, welches einem heißen Gas aussetzbar ist, mit einem metallischen Grundkörper (1), an den eine keramische Wärmedämmschicht (4) angebunden ist, die ein ternäres oder pseudoternäres Oxid aufweist, dadurch gekennzeichnet, daß das Oxid eine Pyrochlor- Kristallstruktur der Strukturformel A₂B₂O₇ aufweist.

2. Erzeugnis nach Anspruch 1,
bei dem das Oxid ein Metall-Hafnat, Metall-Zirkonat oder Metall-Cerat oder eine Mischform dieser Oxide ist.

3. Erzeugnis nach Anspruch 2, bei dem das Oxid als Element für A Lanthan, Aluminium und/oder Cer aufweist.

4. Erzeugnis nach Anspruch 3, bei dem das Oxid Lanthanhafnat aufweist.

5. Erzeugnis, welches einem heißen Gas aussetzbar ist, mit einem metallischen Grundkörper (1), an den eine keramische Wärmedämmschicht (4) angebunden ist, die ein ternäres oder pseudoternäres Oxid aufweist, dadurch gekennzeichnet, daß das Oxid eine Perowskit- Kristallstruktur der Strukturformel ABO₃ aufweist, wobei A für Ytterbium und B für Hafnium oder Zirkon steht oder A für Kalzium und B für Hafnium steht.

6. Erzeugnis nach einem der vorhergehenden Ansprüche, bei dem zwischen Grundkörper (1) und Wärmedämmschicht (4) eine ein Anbindungsoxid aufweisende Anbindungsschicht (3) gebildet ist.

7. Erzeugnis nach einem der Ansprüche 1 bis 6, das eine ein Anbindungsoxid bildende Haftvermittlerschicht (2) zwischen Grundkörper (1) und Wärmedämmschicht (4) aufweist.

8. Erzeugnis nach einem der vorhergehenden Ansprüche, bei dem das Anbindungsoxid Aluminiumoxid und/oder Chromoxid ist.

9. Erzeugnis nach einem der vorhergehenden Ansprüche, bei dem das Oxid zwischen Raumtemperatur und einer maximal zulässigen Einsatztemperatur, die 1250 °C übersteigt, keine Phasenumwandlung erfährt.

10. Erzeugnis nach einem der vorhergehenden Ansprüche, bei dem das Oxid eine Schmelztemperatur oberhalb von 2150 °C besitzt.

11. Erzeugnis nach einem der vorhergehenden Ansprüche, bei dem die Wärmedämmschicht (4) Poren oder andere voluminöse Fehlstellen aufweist.

12. Erzeugnis nach einem der vorhergehenden Ansprüche, bei dem die Wärmedämmschicht (4) eine kolumnare Mikrostruktur aufweist, wobei die Achsenrichtung der Kristallite senkrecht auf der Oberfläche des Grundkörpers (1) steht.

13. Erzeugnis nach einem der vorhergehenden Ansprüche, welches ein heißgasbelastbares Bauteil einer Verbrennungsmaschine, insbesondere einer Gasturbine, ist.

14. Verfahren zur Herstellung eines heißgasbelastbaren Erzeugnisses mit einem metallischen Grundkörper (1), wobei eine keramische Wärmedämmschicht (4) mit einem ternären oder pseudoternären Oxid, das eine Pyrochlor- Kristallstruktur der Strukturformel A₂B₂O₇ aufweist, durch Plasmaspritzen oder ein PVD-Verfahren, insbesondere ein Elektronen-Strahl-PVD-Verfahren, auf den Grundkörper (1) aufgebracht wird.

## Claims

1. Product which can be exposed to a hot gas and has a metallic base body (1) to which a ceramic thermal barrier layer (4), which has a ternary or pseudoternary oxide, is bonded, characterized in that the oxide has a pyrochlore crystal structure of the structural formula A₂B₂O₇.

2. Product according to Claim 1, in which the oxide is a metal hafnate, metal zirconate or metal cerate or a mixed form of these oxides.

3. Product according to Claim 2, in which the oxide has lanthanum, aluminium and/or cerium as the element for A.

4. Product according to Claim 3, in which the oxide has lanthanum hafnate.

5. Product which can be exposed to a hot gas and has a metallic base body (1) to which a ceramic thermal barrier layer (4), which has a ternary or pseudoternary oxide, is bonded, characterized in that the oxide has a perovskite crystal structure of the structural formula ABO₃ where A represents ytterbium and B represents hafnium or zirconium or A represents calcium and B represents hafnium.

6. Product according to one of the preceding claims, in which a bonding layer (3) having a bonding oxide is formed between the base body (1) and the thermal barrier layer (4).

7. Product according to one of Claims 1 to 6, which, between the base body (1) and the thermal barrier layer (4), has an adhesion promoter layer (2) forming a bonding oxide.

8. Product according to one of the preceding claims, in which the bonding oxide is aluminium oxide and/or chromium oxide.

9. Product according to one of the preceding claims, in which the oxide undergoes no phase transition between room temperature and a maximum permissible working temperature which is higher than 1250°C.

10. Product according to one of the preceding claims, in which the oxide has a melting temperature above 2150°C.

11. Product according to one of the preceding claims, in which the thermal barrier layer (4) has pores or other voluminous defects.

12. Product according to one of the preceding claims, in which the thermal barrier layer (4) has a columnar microstructure, the axial direction of the crystallites being perpendicular to the surface of the base body (1).

13. Product according to one of the preceding claims, which is a component that belongs to a combustion machine, in particular a gas turbine, and can be subjected to hot gas.

14. Process for producing a product which can be subjected to hot gas and has a metallic base body (1), a ceramic thermal barrier layer (4) having a ternary or pseudoternary oxide which has a pyrochlore crystal structure of the structural formula A₂B₂O₇ being applied to the base body (1) by plasma spraying or a PVD method, in particular an electron beam PVD method.

## Revendications

1. Produit pouvant être exposé à un gaz chaud, comportant un corps de base métallique (1) auquel est liée une couche calorifuge céramique (4) comportant un oxyde ternaire ou pseudo-ternaire, caractérisé en ce que l'oxyde présente une structure cristalline de type pyrochlore de formule A₂B₂O₇.

2. Produit selon la revendication 1, dans lequel l'oxyde est un hafnate métallique, un zirconate métallique ou un cérate métallique, ou un mélange de ces oxydes.

3. Produit selon la revendication 2, dans lequel l'oxyde contient, en tant qu'élément A, du lanthane, de l'aluminium et/ou du cérium.

4. Produit selon la revendication 3, dans lequel l'oxyde comporte du hafnate de lanthane.

5. Produit pouvant être exposé à un gaz chaud, comportant un corps de base métallique (1) auquel est liée une couche calorifuge céramique (4) comportant un oxyde ternaire ou pseudo-ternaire, caractérisé en ce que l'oxyde a une structure cristalline de type perowskite de formule ABO₃, où A est l'ytterbium et B le hafnium ou le zirconium, ou encore A est le calcium et B est le hafnium.

6. Produit selon l'une des revendications précédentes, dans lequel une couche de liaison (3) comportant un oxyde de liaison est formée entre le corps de base (1) et la couche calorifuge (4).

7. Produit selon l'une des revendications 1 à 6, qui entre le corps de base (1) et la couche calorifuge (4) comporte une couche promotrice d'adhérence (2) formant un oxyde de liaison.

8. Produit selon l'une des revendications précédentes, dans lequel l'oxyde de liaison est l'oxyde d'aluminium et/ou l'oxyde de chrome.

9. Produit selon l'une des revendications précédentes, dans lequel l'oxyde ne subit aucun changement de phase entre la température ambiante et une température maximale admissible d'utilisation, qui est supérieure à 1250°C.

10. Produit selon l'une des revendications précédentes, dans lequel l'oxyde a une température de fusion supérieure à 2150°C.

11. Produit selon l'une des revendications précédentes, dans lequel la couche calorifuge (4) comporte des pores ou d'autres lacunes volumineuses.

12. Produit selon l'une des revendications précédentes, dans lequel la couche calorifuge a une microstructure en forme de colonne, la direction des axes des cristallites étant perpendiculaire à la surface du corps de base (1).

13. Produit selon l'une des revendications précédentes, qui est un élément, pouvant être exposé à un gaz chaud, d'une machine à combustion interne, en particulier une turbine à gaz.

14. Procédé de fabrication d'un produit pouvant être exposé à un gaz chaud, comportant un corps de base métallique (1), où une couche calorifuge céramique (4), comportant un oxyde ternaire ou pseudo-ternaire ayant une structure cristalline de type pyrochlore de formule A₂B₂O₇, est appliquée sur le corps de base (1) par pulvérisation par plasma ou par un procédé PVD, en particulier un procédé PVD à faisceau d'électrons.
